# EUROPÄISCHE PATENTSCHRIFT

(11) **EP 3 793 332 B1**
(45) Veröffentlichungstag und Bekanntmachung des Hinweises auf die Patenterteilung: **18.01.2023**
(21) Anmeldenummer: 19197484.9
(22) Anmeldetag: 16.09.2019
(51) Int. Cl.: H05G 1/10, H05G 1/26

(54) **SPANNUNGSVERSORGUNG FÜR EINEN RÖNTGENSTRAHLER, RÖNTGENEINRICHTUNG UND VERFAHREN ZUM TESTEN EINER RÖNTGENEINRICHTUNG**
POWER SUPPLY FOR AN X-RAY DEVICE, X-RAY DEVICE AND METHOD FOR TESTING AN X-RAY DEVICE
ALIMENTATION ÉLECTRIQUE POUR UN ÉMETTEUR DE RAYONS X, ÉMETTEUR DE RAYONS X ET PROCÉDÉ D'ESSAI D'UN ÉMETTEUR DE RAYONS X

(43) Veröffentlichungstag der Anmeldung: 17.03.2021
(73) Patentinhaber: Siemens Healthcare GmbH, 91052 Erlangen (DE)
(72) Erfinder: Böhme, Andreas, 90411 Nürnberg (DE); Bauer, Florian, 91052 Erlangen (DE); Klinger, Peter, 91080 Uttenreuth (DE)

(56) Entgegenhaltungen:
- JP-A- H08 213 188
- US-A- 5 241 260

## Beschreibung

Die Erfindung betrifft eine Spannungsversorgung für einen Röntgenstrahler mit einem ersten und zweiten Hochspannungsanschluss zum Anschluss des Röntgenstrahlers, wobei eine Spannungsquelle der Spannungsversorgung dazu eingerichtet ist, eine Beschleunigungsspannung oder eine Heizspannung zwischen einem ersten internen Kontakt und einem zweiten internen Kontakt der Spannungsversorgung bereitzustellen, um in einem ersten Betriebsmodus der Spannungsversorgung den Röntgenstrahler zu bestromen. Daneben betrifft die Erfindung eine Röntgeneinrichtung sowie ein Verfahren zum Testen einer Röntgeneinrichtung.

In Röntgeneinrichtungen sind Röntgenstrahler, z. B. Röntgenröhren, Verschleißteile. Somit ist es durchaus zu erwarten, dass im Rahmen des normalen Betriebs in gewissen zeitlichen Abständen Störungen auftreten, die zu einem Ausfall der Röntgeneinrichtung führen können. Durch Überwachung der Spannungsversorgung können entsprechende Probleme häufig erkannt werden. So ist ein Emitterausfall häufig auf ein beschädigtes Filament zurückzuführen, was anhand einer Störung des Heizstroms erkennbar ist. Andere Beschädigungen, beispielsweise Kurzschlüsse, können durch Auswertung von Spannungseinbrüchen erkannt werden. Für diesen Zweck offenbart JP H08 213 188 A eine Hochspannungsversorgung für einen Röntgenstrahler, welche im Fall von Unregelmäßigkeiten während des Betriebs des Röntgenstrahlers abgetrennt wird, und wobei vor einer eventuellen Wiederinbetriebnahme der Röntgenstrahler und die Hochspannungsversorgung hinsichtlich eventueller Abweichungen vom Normzustand untersucht werden.

Da ein Großteil der genannten Probleme durch einen Austausch des Röntgenstrahlers behoben werden kann, wird bei Problemen im Heizkreis bzw. bei Hochspannungsproblemen in der Regel zunächst der Röntgenstrahler getauscht. Dies führt jedoch dazu, dass Schäden der Spannungsversorgung, beispielsweise ein fehlerhafter Heiz- oder Hochspannungstransformator, typischerweise erst erkannt werden, nachdem der Röntgenstrahler gewechselt wurde und das Problem weiterhin besteht. Da der Servicetechniker entsprechende Ersatzteile typischerweise nicht mit sich führt, muss typischerweise ein zweiter Service angesetzt werden, was zu längeren Nichtbetriebszeiten der Röntgeneinrichtung führt. Zudem können unnötige Kosten entstehen, da ein unnötiger Austausch des Röntgenstrahlers erfolgen kann.

Alternativ wäre es möglich, zunächst ausschließlich Messungen zur Ermittlung der Fehlerquelle durchzuführen. Beispielsweise können externe Geräte angeschlossen werden, um eine Messung von Hochspannung ohne angeschlossenen Röntgenstrahler bzw. eine Messung der Heizspannung zu ermöglichen. Entsprechende Servicemittel sind jedoch nicht immer verfügbar.

Es wäre auch möglich, unmittelbar die Stromversorgung zu wechseln bzw. Komponenten der Stromversorgung zu wechseln, um die Funktionsfähigkeit des Röntgenstrahlers zu testen. Auch dieses Vorgehen ist sehr aufwändig und erfordert große und schwere zusätzliche Komponenten.

Der Erfindung liegt somit die Aufgabe zugrunde, eine Möglichkeit anzugeben, mit geringem technischen Aufwand eine bessere Wartbarkeit eine Röntgeneinrichtung zu erreichen und insbesondere bei Vorliegen eines Fehlers mögliche Fehlerquellen einzuschränken.

Die Aufgabe wird erfindungsgemäß durch eine Spannungsversorgung der eingangs genannten Art gelöst, wobei die Spannungsversorgung eine Steuereinrichtung umfasst, die dazu eingerichtet ist, in einem zweiten Betriebsmodus eine Spannung zwischen dem ersten und dem zweiten internen Kontakt und/oder einen Strom über den ersten und/oder den zweiten internen Kontakt zu erfassen und in Abhängigkeit der erfassten Spannung und/oder des erfassten Stroms eine Hinweiseinrichtung zur Hinweisgabe an einen Nutzer anzusteuern und/oder ein Hinweissignal an eine externe Einrichtung zu übertragen, wobei eine Schalteinrichtung der Spannungsversorgung dazu eingerichtet ist, den ersten internen Kontakt in dem ersten Betriebsmodus mit dem ersten Hochspannungsanschluss zu verbinden und in dem zweiten Betriebsmodus von diesem zu trennen, und/oder dazu eingerichtet ist, den zweiten internen Kontakt in dem ersten Betriebsmodus mit dem zweiten Hochspannungsanschluss zu verbinden und in dem zweiten Betriebsmodus von diesem zu trennen, und/oder dazu eingerichtet ist, den ersten und zweiten internen Kontakt im zweiten Betriebsmodus zu verbinden und im ersten Betriebsmodus zu trennen.

Erfindungsgemäß wird vorgeschlagen, in einem zweiten Betriebsmodus zumindest Teile der Hochspannungsanschlüsse von den zugeordneten internen Kontakten zu trennen und/oder die internen Kontakte miteinander zu verbinden. Ein Trennen der internen Kontakte von den Hochspannungsanschlüssen ermöglicht es, diese auch von dem Röntgenstrahler von Hochspannungskabeln, die die Hochspannungsanschlüsse mit dem Röntgenstrahler verbinden, zu entkoppeln. Hierdurch kann ein Einfluss der externen Komponente auf Ströme bzw. Spannungen an diesen internen Kontakten ausgeschlossen werden.

Wird beispielsweise ein Spannungseinbruch zwischen dem ersten und zweiten Kontakt im ersten Betriebsmodus erkannt, kann durch das Trennen zumindest eines der Hochspannungsanschlüsse, vorzugsweise von allen Hochspannungsanschlüssen, von den jeweiligen internen Kontakten jegliche externe Störung ausgeschlossen werden. Wird im zweiten Betriebsmodus somit weiterhin ein Spannungseinbruch erkannt, deutet dies auf einen internen Fehler, beispielsweise auf einen internen Kurzschluss oder einen beschädigten Transformator hin. Tritt ein Spannungseinbruch hingegen im zweiten Betriebsmodus nicht länger auf, kann davon ausgegangen werden, dass er durch externe Komponenten, also den Röntgenstrahler bzw. die diesen mit den Hochspannungsanschlüssen verbindenden Hochspannungskabel verursacht ist. Durch die Nutzung des zweiten Betriebsmodus kann somit zwischen internen Schäden der Spannungsversorgung und externen Fehlern, beispielsweise Leckagen bzw. Kurzschlüssen, die zu Spannungseinbrüchen führen, unterschieden werden.

Wie obig bereits erläutert wurde, ist ein weiteres häufiges Problem, dass Störungen des Heizstroms, insbesondere ein zu geringer Heizstrom, erkannt werden. Dies kann durch Beschädigung von Heizfilamenten des Röntgenstrahlers verursacht sein, jedoch auch durch eine Beschädigung der Stromversorgung, beispielsweise einen beschädigten Niederspannungstransformator, der den Heizstrom bereitstellen soll. Durch eine leitende Verbindung des ersten und zweiten internen Kontakts, entweder direkt oder über einen definierten Widerstand bzw. eine definierte Impedanz, kann eine funktionsfähige Heizung eines Röntgenstrahlers, insbesondere ein funktionsfähiges Heizfilament, simuliert werden. Wird somit auch im zweiten Betriebsmodus ein zu geringer Heizstrom oder eine andere Störung des Heizstroms gemessen, ist dies ein starkes Indiz dafür, dass die Spannungsversorgung bzw. ihre Komponenten beschädigt sind. Wird die Störung des Heizstroms hingegen durch den Wechsel in den zweiten Betriebsmodus beseitigt, kann von einem spannungsversorgungsexternen Problem, insbesondere von einem beschädigten Heizfilament, ausgegangen werden.

Der erste und zweite Hochspannungsanschluss können zur Bestromung von unterschiedlichen Elektroden des Röntgenstrahlers, also zur Bestromung der Kathode und der Anode, dienen. In diesem Fall liegen zwischen dem ersten und zweiten internen Kontakt hohe Spannungen, insbesondere hohe Gleichspannungen, an. Schäden der Spannungsversorgung, des Röntgenstrahlers und der Hochspannungskabel können in diesem Fall insbesondere zu Spannungseinbrüchen führen, so dass in diesem Fall vorzugsweise eine Spannungsmessung erfolgt. Um externe Einflüsse auf die Spannungsversorgung auszuschließen, sollten vorzugsweise beide internen Kontakte von den jeweiligen Hochspannungsanschlüssen getrennt werden. Ein Verbinden des ersten und zweiten internen Kontakts miteinander ist in diesem Fall eher nicht zweckmäßig.

Es ist auch möglich, dass der erste und zweite Hochspannungsanschluss zur Beaufschlagung der Kathode des Röntgenstrahlers mit einer Heizspannung dienen. In diesem Fall kann es besonders vorteilhaft sein, zu prüfen, ob ausreichend Strom über den ersten bzw. zweiten internen Kontakt fließt. In diesem Fall erfolgt somit besonders bevorzugt eine Messung des Stroms, der über den ersten und/oder den zweiten Kontakt fließt. Wie obig erläutert, können im zweiten Betriebsmodus der erste und zweite interne Kontakt leitfähig verbunden werden, um ein funktionierendes Heizfilament zu simulieren und somit zu erkennen, ob eine interne Beschädigung der Spannungsversorgung vorliegt.

Die Hinweisgabe bzw. die Übertragung des Hinweissignals kann insbesondere dann erfolgen, wenn eine Hinweisbedingung erfüllt ist, beispielsweise wenn eine erfasste Spannung bzw. ein erfasster Strom kleiner als ein jeweiliger Grenzwert ist. Alternativ kann von der Erfüllung der Hinweisbedingung auch der Inhalt des gegebenen Hinweises bzw. des Hinweissignals abhängen.

Für Röntgenstrahler, insbesondere im medizinischen Bereich, werden relativ hohe Beschleunigungsspannungen genutzt. Somit kann die Potentialdifferenz zwischen dem ersten und zweiten internen Kontakt bzw. insbesondere im ersten Betriebsmodus zwischen dem ersten und zweiten Hochspannungsanschluss mehrere 10 kV oder mehr als 100 kV betragen. Üblich sind beispielsweise Beschleunigungsspannungen zwischen 10 und 150 kV. Beispielsweise können 125 kV, jedoch auch 260 kV oder mehr, als Beschleunigungsspannung verwendet werden. Die Beschleunigungsspannung kann beispielsweise gesteuert werden, indem eine Eingangsspannung eines Hochspannungstransformators variiert wird. Um Leckagen robust zu erkennen, kann es vorteilhaft sein, vor einer Spannungsmessung zur Erkennung von Defekten eine maximale Ausgangsspannung einzustellen oder zwischen dem ersten und zweiten internen Kontakt abfallende Spannungen für mehrere gewünschte Ausgangsspannungen zu messen.

Die Spannungsquelle kann einen weiteren internen Kontakt aufweisen und dazu eingerichtet sein, eine Beschleunigungsspannung zwischen dem weiteren internen Kontakt und dem ersten und/oder zweiten internen Kontakt anzulegen, wobei die Schalteinrichtung dazu eingerichtet ist, den weiteren internen Kontakt in dem ersten Betriebsmodus mit einem weiteren Hochspannungsanschluss zu verbinden und in dem zweiten Betriebsmodus von diesem zu trennen. Insbesondere kann in diesem Fall zwischen dem ersten und zweiten internen Kontakt eine Heizspannung angelegt werden. Die Hochspannungsanschlüsse zur Bereitstellung einer Heizspannung stellen somit im ersten Betriebsmodus zugleich ein Gegenpotential für die Beschleunigungsspannung dar. Dies ist an sich im Stand der Technik bekannt und soll daher nicht detailliert erläutert werden. Durch die vorgeschlagene Möglichkeit, auch den weiteren internen Kontakt von dem zugeordneten Hochspannungsanschluss und somit von dem Röntgenstrahler zu trennen, kann die Spannungsversorgung insbesondere vollständig von dem Röntgenstrahler bzw. den diesen mit der Spannungsversorgung verbindenden Hochspannungskabeln entkoppelt werden, womit eine robuste Unterscheidung zwischen internen Fehlern der Spannungsversorgung und externen Fehlern, beispielsweise der Kabel bzw. des Röntgenstrahlers, erreicht werden kann.

Die beschriebenen Anzahlen von Hochspannungsanschlüssen bzw. internen Kontakten sind nicht einschränkend. Beispielsweise können drei oder auch mehr Hochspannungsanschlüsse zu einer Kathode des Röntgenstrahlers geführt werden, um mehrere Heizfilamente zu beschicken. In einer besonders vorteilhaften Ausgestaltung können alle Hochspannungsanschlüsse der Spannungsversorgung, die diese mit dem Röntgenstrahler koppeln, von den zugehörigen internen Kontakten getrennt werden und/oder alle internen Kontakte, die zur Bereitstellung einer Heizspannung bzw. eines Heizstroms dienen, können im zweiten Betriebsmodus miteinander verbunden werden.

Die Spannungsversorgung kann zur gleichzeitigen oder alternativen Bestromung mehrerer Röntgenstrahler dienen. Im ersten Betriebsmodus können die Hochspannungsanschlüsse für einen ausgewählten der Röntgenstrahler oder für beide Röntgenstrahler durch die Schalteinrichtung mit jeweils zugeordneten internen Kontakten verbunden werden. Im zweiten Betriebsmodus können die Hochspannungsanschlüsse für alle Röntgenstrahler von den internen Kontakten getrennt werden.

Als Heizspannung kann insbesondere eine Wechselspannung genutzt werden. Die Heizspannung bzw. die Amplitude der Heizspannung kann erheblich kleiner sein als eine durch die Spannungsversorgung bereitgestellte Beschleunigungsspannung, insbesondere wenigstens um den Faktor 10 oder 100 kleiner.

Die Steuereinrichtung kann dazu eingerichtet sein, in dem zweiten Betriebsmodus eine Spannung zwischen dem weiteren internen Kontakt und dem ersten oder zweiten internen Kontakt zu erfassen, wobei die Ansteuerung der Hinweiseinrichtung und/oder die Übertragung des Hinweissignals zusätzlich von dieser Spannung abhängt. Insbesondere kann somit die korrekte Bereitstellung der Beschleunigungsspannung durch die Spannungsversorgung geprüft werden, wobei gleichzeitig oder auch zu einem anderen Zeitpunkt, wie obig erläutert, die korrekte Bereitstellung einer Heizspannung bzw. eines Heizstroms geprüft werden kann.

Die Steuereinrichtung kann dazu eingerichtet sein, im ersten Betriebsmodus den Strom über den ersten und/oder zweiten internen Kontakt und/oder die Spannung zwischen dem ersten und dem zweiten internen Kontakt und/oder die Spannung zwischen dem weiteren und dem ersten und/oder zweiten internen Kontakt als jeweilige Messgröße zu erfassen und bei Erfüllung einer Wechselbedingung, die von der Messgröße oder den Messgrößen abhängt, die Spannungsversorgung in den zweiten Betriebsmodus umzuschalten. Ein Umschalten in den zweiten Betriebsmodus kann insbesondere erfolgen, wenn die erfasste Spannung oder der erfasste Strom einen jeweiligen Grenzwert unterschreiten oder anderweitig als fehlerbehaftet erkannt wird, beispielsweise aufgrund von sprunghaften Änderungen.

Eine Erfüllung der Wechselbedingung kann darauf hindeuten, dass die Bereitstellung einer Beschleunigungsspannung bzw. Heizspannung bzw. eines Heizstroms gestört ist. Dies kann, wie eingangs erläutert, externe Ursachen, also insbesondere eine Beschädigung des Röntgenstrahlers bzw. der Hochspannungskabel, oder interne Ursachen, beispielsweise eine Beschädigung eines Heiz- bzw. Beschleunigungsspannungstransformators, haben. Durch das beschriebene Vorgehen kann bei Erkennung eines möglichen Fehlers in den zweiten Betriebsmodus gewechselt werden, um zu prüfen, ob ein interner Fehler der Spannungsversorgung vorliegt. Anschließend kann ein entsprechender Hinweis an einen Nutzer gegeben werden bzw. ein Hinweissignal an eine externe Einrichtung übertragen werden, der bzw. das entsprechende Informationen umfassen kann. Somit können beispielsweise unmittelbar Informationen bereitgestellt werden, ob voraussichtlich ein interner oder ein externer Defekt vorliegt. Anhand dieser Informationen kann ermöglicht werden, dass unmittelbar die voraussichtlich korrekten Ersatzteile bereitgestellt werden bzw. es können aufwändige Messungen eines Servicetechnikers vermieden werden. Insgesamt kann somit ein kürzeres Wartungsintervall einer Röntgeneinrichtung bei auftretenden Fehlern erreicht werden und es können partiell Kosten gespart werden.

Ergänzend oder alternativ zu dem obig beschriebenen automatischen Wechsel in den zweiten Betriebsmodus kann es auch möglich sein, einen Betrieb im zweiten Betriebsmodus manuell an der Spannungsversorgung bzw. an einer mit dieser kommunizierenden Einrichtung, beispielsweise einem Steuerrechner einer Röntgeneinrichtung, auszulösen. Beispielsweise kann es im Rahmen einer Installation oder Wartung unabhängig von bereits vorangehend erkannten Fehlern zweckmäßig sein, Funktionen der Spannungsversorgung zu testen.

Die Schaltvorrichtung kann einen ersten Ölschalter, der in dem ersten Betriebsmodus den ersten internen Kontakt mit dem ersten Hochspannungsanschluss verbindet und in dem zweiten Betriebsmodus von diesem trennt, und/oder einen zweiten Ölschalter, der in dem ersten Betriebsmodus den zweiten internen Kontakt mit dem zweiten Hochspannungsanschluss verbindet und in dem zweiten Betriebsmodus von diesem trennt, umfassen. Insbesondere können alle erläuterten Schaltvorgänge, also insbesondere auch das Verbinden von internen Kontakten der Spannungsversorgung, durch Ölschalter realisiert werden. Ölschalter sind Leistungsschalter, bei denen sich der Schalter in einem mit Öl gefüllten Gefäß befindet. Das Öl dient dabei zur Löschung des bei einem Schaltvorgang auftretenden Schaltlichtbogens. Ölschalter sind an sich im Stand der Technik bekannt und sollen nicht detailliert erläutert werden.

Soweit in der erfindungsgemäßen Spannungsversorgung die Hochspannungsanschlüsse von den jeweiligen zugeordneten internen Kontakten getrennt werden, können die Hochspannungsanschlüsse auf einem schwebenden Potential liegen. Es ist jedoch auch möglich, die Hochspannungsanschlüsse auf ein definiertes Potential, beispielsweise ein Massepotential, zu ziehen.

Neben der erfindungsgemäßen Spannungsversorgung betrifft die Erfindung eine Röntgeneinrichtung, insbesondere zur medizinischen Bildgebung, mit einem Röntgenstrahler zur Erzeugung von Röntgenstrahlung, wobei die Röntgeneinrichtung eine erfindungsgemäße Spannungsversorgung umfasst.

Zudem betrifft die Erfindung ein Verfahren zum Testen einer Röntgeneinrichtung, wobei ein Röntgenstrahler, der zur Erzeugung von Röntgenstrahlung dient, in einem ersten Betriebsmodus einer Spannungsversorgung durch einen ersten und zweiten Hochspannungsanschluss der Spannungsversorgung bestromt wird, indem eine Beschleunigungsspannung oder eine Heizspannung zwischen einem ersten internen Kontakt und einem zweiten internen Kontakt der Spannungsversorgung bereitgestellt wird, wobei durch eine Schalteinrichtung der erste interne Kontakt mit dem ersten Hochspannungsanschluss und der zweite interne Kontakt mit dem zweiten Hochspannungsanschluss verbunden wird, wobei bei Erfüllung einer Wechselbedingung die Spannungsversorgung in einen zweiten Betriebsmodus umgeschaltet wird, in dem die Schalteinrichtung den ersten internen Kontakt von dem ersten Hochspannungsanschluss und/oder den zweiten internen Kontakt von dem zweiten Hochspannungsanschluss trennt und im Falle der Bereitstellung der Heizspannung den ersten und zweiten internen Kontakt leitfähig miteinander verbindet, wonach durch eine Steuereinrichtung ein Strom über den ersten und/oder zweiten internen Kontakt erfasst wird, oder im Falle der Bereitstellung der Beschleunigungsspannung eine Spannung zwischen dem ersten und dem zweiten internen Kontakt erfasst wird und in Abhängigkeit der erfassten Spannung bzw. des erfassten Stroms eine Hinweiseinrichtung zur Hinweisgabe an einen Nutzer angesteuert und/oder ein Hinweissignal an eine externe Einrichtung übertragen wird.

Wie bereits zur erfindungsgemäßen Spannungsversorgung erläutert, kann die Erfüllung der Wechselbedingung von dem erfassten Strom bzw. der erfassten Spannung abhängen. Ergänzend oder alternativ kann die Erfüllung der Wechselbedingung von einer Spannung zwischen einem weiteren internen Kontakt und dem ersten bzw. zweiten internen Kontakt abhängen, wie ebenfalls bereits zur erfindungsgemäßen Spannungsversorgung erläutert wurde. Die Wechselbedingung kann jedoch auch dann erfüllt sein, wenn ein manueller Wechsel in den zweiten Betriebsmodus ausgelöst wurde, beispielsweise durch ein Bedienelement an der Spannungsversorgung bzw. einer weiteren Komponente der Messeinrichtung oder durch ein Signal einer externen Einrichtung, beispielsweise durch eine Fernabfrage eines Servicetechnikers oder Ähnliches.

Die verschiedenen zur Spannungsversorgung erläuterten Merkmale können mit den dort genannten Vorteilen auf das erfindungsgemäße Verfahren übertragen werden. Insbesondere kann die Hinweisgabe bzw. die Übertragung des Hinweissignals von einer weiteren Spannung abhängen, die zwischen dem ersten oder zweiten internen Kontakt und einem weiteren internen Kontakt abfällt. Der weitere interne Kontakt kann zunächst im ersten Betriebsmodus mit einem weiteren Hochspannungsanschluss der Spannungsversorgung verbunden sein und im zweiten Betriebsmodus durch die Schalteinrichtung von diesem getrennt werden.

Weitere Vorteile und Einzelheiten der Erfindung werden im Folgenden anhand von Ausführungsbeispielen sowie der zugehörigen Zeichnung erläutert. Hierbei zeigt die Figur ein Ausführungsbeispiel einer erfindungsgemäßen Röntgeneinrichtung, die ein Ausführungsbeispiel einer erfindungsgemäßen Spannungsversorgung umfasst und durch die ein Ausführungsbeispiel des erfindungsgemäßen Verfahrens durchführbar ist.

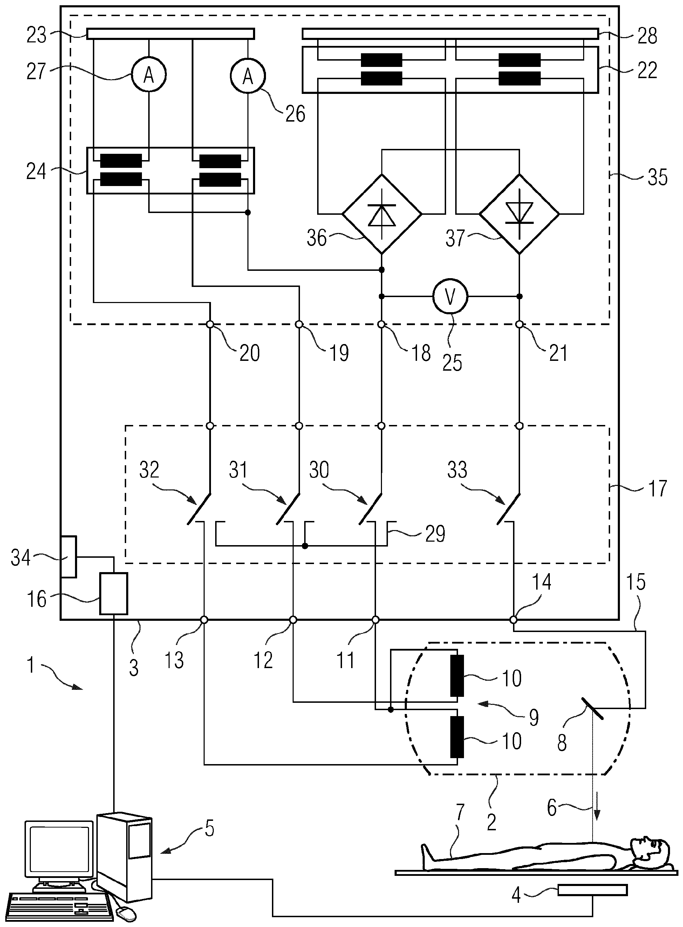

Fig. 1 zeigt eine Röntgeneinrichtung 1, die beispielsweise zur medizinischen Bildgebung dienen kann. Durch einen Röntgenstrahler 2 wird Röntgenstrahlung 6 erzeugt, die, nachdem sie durch ein Untersuchungsobjekt 7, beispielsweise einen Patienten, hindurchgetreten ist, auf einen Röntgendetektor 4 trifft. Durch eine Einrichtung 5, beispielsweise einen Steuer- und/oder Auswerterechner der Röntgeneinrichtung 1, können die Messdaten des Röntgendetektors 4 erfasst werden und beispielsweise zur Bildgebung genutzt werden. Zudem steuert die Einrichtung 5 die Spannungsversorgung 3 der Röntgeneinrichtung 1, um den Röntgenstrahler 2 zu bestromen.

Die Bestromung des Röntgenstrahlers 2 erfolgt einerseits über einen ersten, zweiten und dritten Hochspannungsanschluss 11, 12, 13 der Spannungsversorgung 3, über die die Filamente 10 der Kathode 9 des Röntgenstrahlers bestromt werden, um die Kathode 9 zu beheizen. Über einen weiteren Hochspannungsanschluss 14 wird andererseits die Anode 8 derart mit Spannung beaufschlagt, dass eine hohe Beschleunigungsspannung von beispielsweise 125 kV zwischen der Kathode 9 und der Anode 8 anliegt. Durch diese Beschleunigungsspannung werden aus der heißen Kathode austretende Elektronen in Richtung der Anode 8 beschleunigt und treffen somit mit hoher Geschwindigkeit auf diese auf und erzeugen somit die Röntgenstrahlung 6. In Fig. 1 ist aus Übersichtlichkeitsgründen eine feststehende Anode dargestellt, wobei typischerweise Drehanoden genutzt werden. Das beschriebene Vorgehen zur Erzeugung von Röntgenstrahlung ist prinzipiell bekannt und soll daher nicht detailliert erläutert werden.

Bei solchen Röntgeneinrichtungen 1 ist ein gewisser Verschleiß des Röntgenstrahlers 2 zu erwarten. Insbesondere können die Filamente 10 beschädigt werden und keine ausreichende Heizung der Kathode 9 mehr ermöglichen bzw. es können aufgrund der hohen genutzten Spannungen Leckagen auftreten, wodurch die Beschleunigungsspannung einbricht. In beiden Fällen ist keine robuste Erzeugung von Röntgenstrahlung 6 mehr möglich, weshalb die beschädigten Komponenten im Rahmen eines Service gewechselt werden sollten. Eine Beschädigung der Filamente 10 kann insbesondere erkannt werden, indem durch eine Steuereinrichtung 16 der Spannungsversorgung 3 über die Amperemeter 26, 27 Heizströme erfasst werden. Ein zu geringer Heizstrom deutet auf eine Beschädigung eines Filaments 10 hin. Problematisch ist hierbei, dass eine Beschädigung des Filaments 10 und somit ein externer Fehler hierbei nicht ohne weiteres von einer Beschädigung der Spannungsversorgung 3, beispielsweise des Transformators 24 für die Heizströme, unterschieden werden kann.

Kurzschlüsse bzw. Leckagen im Röntgenstrahler 2 bzw. in Hochspannungskabeln 15 können hingegen durch Überwachung der Beschleunigungsspannung durch das Voltmeter 25 erfasst werden. Auch hierbei können externe Leckagen und Kurzschlüsse jedoch nicht von internen Leckagen oder Kurzschlüssen der Spannungsversorgung 3 bzw. beispielsweise von einer Beschädigung des Transformators 22 für die Hochspannung unterschieden werden.

Um eine solche Unterscheidung zwischen internen und externen Schäden zu ermöglichen und somit insbesondere einen schnelleren bzw. günstigeren Service der Röntgeneinrichtung 1 zu ermöglichen, kann die Spannungsversorgung 3 in zwei unterschiedlichen Betriebsmodi betrieben werden. In einem ersten Betriebsmodus werden wie üblich Heizspannungen und eine Beschleunigungsspannung für den Röntgenstrahler 3 bereitgestellt. Zur Bereitstellung einer Beschleunigungsspannung wird zunächst durch eine Vorstufe 28, die wie üblich aufgebaut ist und nicht näher erläutert werden soll, eine Wechselspannung vorgegeben, die über den Transformator 22 zu einer Hochspannung transformiert wird, die durch die Gleichrichter 36, 37 gleichgerichtet wird und an einem ersten und weiteren internen Kontakt 18, 21 der Spannungsquelle 35 bereitgestellt wird. Eine Schalteinrichtung 17 verbindet im ersten Betriebsmodus den ersten internen Kontakt 18 mit dem ersten Hochspannungsanschluss 11 und den weiteren internen Kontakt 21 mit dem weiteren Hochspannungsanschluss 14.

Zur Bereitstellung der Heizspannung werden wiederum durch eine an sich bekannte Eingangsstufe 23, die nicht näher erläutert werden soll, Wechselspannungen bereitgestellt, die durch den Transformator 24 umgesetzt werden, so dass eine Heizspannung zwischen dem ersten internen Kontakt 18 und dem zweiten und dritten internen Kontakt 19, 20 resultiert. Der zweite interne Kontakt 19 wird über die Schalteinrichtung 17 mit dem zweiten Hochspannungsanschluss 12 und der dritte interne Kontakt 20 wird über die Schalteinrichtung 17 mit dem dritten Hochspannungsanschluss 13 verbunden. Somit entspricht die Bestromung des Röntgenstrahlers 2 im ersten Betriebsmodus einer üblichen Bestromung eines Röntgenstrahlers.

Wird im Rahmen des Betriebs im ersten Betriebsmodus erkannt, dass der Heizstrom bzw. die Beschleunigungsspannung gestört ist, beispielsweise weil die über das Voltmeter 25 erfasste Spannung zwischen den internen Kontakten 18 und 21 bzw. die über die Amperemeter 26, 27 erfassten Ströme über die internen Kontakte 18, 19, 20 einen Grenzwert unterschreiten oder sprunghaft schwanken, so deutet dies darauf hin, dass entweder eine der externen Komponenten, also insbesondere der Röntgenstrahler 2 bzw. eines der Hochspannungskabel 15, oder die Spannungsversorgung 3 bzw. eine von deren Komponenten beschädigt ist.

Um zu erkennen, ob ein interner oder externer Fehler vorliegt, kann die Steuereinrichtung 16 in diesem Fall die Spannungsversorgung 3 in einen zweiten Betriebsmodus schalten. In diesem trennt die Schalteinrichtung 17 alle internen Kontakte 18, 19, 20, 21 von den jeweils zugeordneten Hochspannungsanschlüssen 11, 12, 13, 14. Dies führt dazu, dass die über das Voltmeter 25 erfasste Spannung zwischen den internen Kontaktpunkten 18 und 21 im zweiten Betriebsmodus unabhängig von dem Zustand der externen Komponenten, also des Röntgenstrahlers 2 und der Hochspannungskabel 15, ist. Wird weiterhin eine Störung dieser Spannung, also beispielsweise ein zu niedriger Wert oder eine sprunghafte Änderung, erfasst, deutet dies darauf hin, dass die Spannungsversorgung 3 und insbesondere der Transformator 22 beschädigt sein könnte. Ist hingegen nach dem Wechsel in den zweiten Betriebsmodus die Störung der Beschleunigungsspannung behoben, deutet dies darauf hin, dass diese Störung durch eine externe Komponente, also insbesondere durch den Röntgenstrahler 2 bzw. die Hochspannungskabel 15, verursacht ist.

Im zweiten Betriebsmodus wird zusätzlich der erste interne Kontakt 18 über die Kurzschlussbrücke 29 der Schalteinrichtung 17 mit dem zweiten und dritten internen Kontakt 19, 20 kurzgeschlossen. Hierdurch wird näherungsweise ein Stromfluss durch die internen Kontakte 18, 19, 20 und somit durch die Amperemeter 26, 27 erreicht, wie er erreicht würde, wenn ein Röntgenstrahler 2 mit funktionstüchtigen Filamenten 10 angeschlossen wäre. Deuten die Strommesswerte, die über die Amperemeter 26, 27 erfasst werden, im zweiten Betriebsmodus weiterhin auf eine Störung des Heizstroms hin, deutet dies auf eine Beschädigung der Spannungsversorgung, insbesondere des Transformators 24, hin. Ist die Störung des Heizstroms hingegen im zweiten Betriebsmodus nicht mehr vorhanden, ist sie voraussichtlich durch eine beschädigte externe Komponente, insbesondere durch ein beschädigtes Filament 10, verursacht.

In Abhängigkeit der im zweiten Betriebsmodus erfassten Spannung und Ströme kann somit entschieden werden, ob voraussichtlich ein interner oder ein externer Defekt vorliegt. Um dies an einen Nutzer zu kommunizieren, kann beispielsweise eine Hinweiseinrichtung 34 der Spannungsversorgung 3 angesteuert werden bzw. ein Hinweissignal an die externe Einrichtung 5 übermittelt werden, um einen Nutzer hierauf hinzuweisen. Während im gezeigten Beispiel nur eine lokale Signalübertragung erfolgt, ist es auch möglich, beispielsweise unmittelbar eine Nachricht an einen Servicetechniker zu senden. Dies ist beispielsweise durch Übertragung einer Textnachricht, durch Senden einer E-Mail oder Ähnliches, möglich.

Die Schalteinrichtung 17 kann durch mehrere Schalter, insbesondere Ölschalter 30, 31, 32, 33, gebildet werden. Eine Nutzung von Ölschaltern 30, 31, 32, 33 ermöglicht es, die auftretenden hohen Spannungen robust zu schalten. Die Ölschalter 30, 31, 32 können Umschalter sein, die zwischen einer Verbindung des jeweiligen internen Kontakts 18, 19, 20 mit dem jeweiligen Hochspannungsanschluss 11, 12, 13 und einer Verbindung des jeweiligen internen Kontakts 18, 19, 20 mit der Kurzschlussbrücke 29 umschalten. Der Ölschalter 33 kann ausschließlich dazu dienen, den internen Kontakt 21 von dem Hochspannungsanschluss 14 zu trennen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Spannungsversorgung für einen Röntgenstrahler (2) mit einem ersten und zweiten Hochspannungsanschluss (11, 12) zum Anschluss des Röntgenstrahlers (2), wobei eine Spannungsquelle (35) der Spannungsversorgung (3) dazu eingerichtet ist, eine Beschleunigungsspannung oder eine Heizspannung zwischen einem ersten internen Kontakt (18) und einem zweiten internen Kontakt (19) der Spannungsversorgung (3) bereitzustellen, um in einem ersten Betriebsmodus der Spannungsversorgung (3) den Röntgenstrahler (3) zu bestromen, **dadurch gekennzeichnet, dass** die Spannungsversorgung (3) eine Steuereinrichtung (16) umfasst, die dazu eingerichtet ist, in einem zweiten Betriebsmodus eine Spannung zwischen dem ersten und dem zweiten internen Kontakt (18, 19) und/oder einen Strom über den ersten und/oder zweiten internen Kontakt (18, 19) zu erfassen und in Abhängigkeit der erfassten Spannung und/oder des erfassten Stroms eine Hinweiseinrichtung (34) zur Hinweisgabe an einen Nutzer anzusteuern und/oder ein Hinweissignal an eine externe Einrichtung (5) zu übertragen, wobei eine Schalteinrichtung (17) der Spannungsversorgung (3) dazu eingerichtet ist, den ersten internen Kontakt (18) in dem ersten Betriebsmodus mit dem ersten Hochspannungsanschluss (11) zu verbinden und in dem zweiten Betriebsmodus von diesem zu trennen, und/oder dazu eingerichtet ist, den zweiten internen Kontakt (19) in dem ersten Betriebsmodus mit dem zweiten Hochspannungsanschluss (12) zu verbinden und in dem zweiten Betriebsmodus von diesem zu trennen, und/oder dazu eingerichtet ist, den ersten und zweiten internen Kontakt (18, 19) im zweiten Betriebsmodus zu verbinden und im ersten Betriebsmodus zu trennen.

2. Spannungsversorgung nach Anspruch 1, **dadurch gekennzeichnet, dass** die Spannungsquelle (35) einen weiteren internen Kontakt (21) aufweist und dazu eingerichtet ist, eine Beschleunigungsspannung zwischen dem weiteren internen Kontakt (21) und dem ersten und/oder zweiten internen Kontakt (18, 19) anzulegen, wobei die Schalteinrichtung (17) dazu eingerichtet ist, den weiteren internen Kontakt (21) in dem ersten Betriebsmodus mit einem weiteren Hochspannungsanschluss (14) zu verbinden und in dem zweiten Betriebsmodus von diesem zu trennen.

3. Spannungsversorgung nach Anspruch 2, **dadurch gekennzeichnet, dass** die Steuereinrichtung (16) dazu eingerichtet ist, in dem zweiten Betriebsmodus eine Spannung zwischen dem weiteren internen Kontakt (21) und dem ersten oder zweiten internen Kontakt (18, 19) zu erfassen, wobei die Ansteuerung der Hinweiseinrichtung (34) und/oder die Übertragung des Hinweissignals zusätzlich von dieser Spannung abhängt.

4. Spannungsversorgung nach einem der vorangehenden Ansprüche, **dadurch gekennzeichnet, dass** die Steuereinrichtung (16) dazu eingerichtet ist, im ersten Betriebsmodus den Strom über den ersten und/oder zweiten internen Kontakt (18, 19) und/oder die Spannung zwischen dem ersten und dem zweiten internen Kontakt (18, 19) und/oder die Spannung zwischen dem weiteren und dem ersten und/oder zweiten internen Kontakt (21, 18, 19) als jeweilige Messgröße zu erfassen und bei Erfüllung einer Wechselbedingung, die von der Messgröße oder den Messgrößen abhängt, die Spannungsversorgung (3) in den zweiten Betriebsmodus umzuschalten.

5. Spannungsversorgung nach einem der vorangehenden Ansprüche, **dadurch gekennzeichnet, dass** die Schaltvorrichtung (17) einen ersten Ölschalter (30), der in dem ersten Betriebsmodus den ersten internen Kontakt (18) mit dem ersten Hochspannungsanschluss (11) verbindet und in dem zweiten Betriebsmodus von diesem trennt, und/oder einen zweiten Ölschalter (31), der in dem ersten Betriebsmodus den zweiten internen Kontakt (19) mit dem zweiten Hochspannungsanschluss (12) verbindet und in dem zweiten Betriebsmodus von diesem trennt, umfasst.

6. Röntgeneinrichtung, insbesondere zur medizinischen Bildgebung, mit einem Röntgenstrahler (2) zur Erzeugung von Röntgenstrahlung (6), **dadurch gekennzeichnet, dass** die Röntgeneinrichtung (1) eine Spannungsversorgung (3) nach einem der vorangehenden Ansprüche umfasst.

7. Verfahren zum Testen einer Röntgeneinrichtung (1), wobei ein Röntgenstrahler (2), der zur Erzeugung von Röntgenstrahlung (6) dient, in einem ersten Betriebsmodus einer Spannungsversorgung (3) durch einen ersten und zweiten Hochspannungsanschluss (11, 12) der Spannungsversorgung (3) bestromt wird, indem eine Beschleunigungsspannung oder eine Heizspannung zwischen einem ersten internen Kontakt (18) und einem zweiten internen Kontakt (19) der Spannungsversorgung (3) bereitgestellt wird, wobei durch eine Schalteinrichtung (17) der erste interne Kontakt (18) mit dem ersten Hochspannungsanschluss (11) und der zweite interne Kontakt (19) mit dem zweiten Hochspannungsanschluss (12) verbunden wird, wobei bei Erfüllung einer Wechselbedingung die Spannungsversorgung (3) in einen zweiten Betriebsmodus umgeschaltet wird, in dem die Schalteinrichtung (17) den ersten internen Kontakt (18) von dem ersten Hochspannungsanschluss (11) und/oder den zweiten internen Kontakt (19) von dem zweiten Hochspannungsanschluss (12) trennt und im Falle der Bereitstellung der Heizspannung den ersten und zweiten internen Kontakt (18, 19) leitfähig miteinander verbindet, wonach durch eine Steuereinrichtung (16) ein Strom über den ersten und/oder den zweiten internen Kontakt (18, 19) erfasst wird, oder im Falle der Bereitstellung der Beschleunigungsspannung eine Spannung zwischen dem ersten und dem zweiten internen Kontakt (18, 19) erfasst wird und in Abhängigkeit der erfassten Spannung bzw. des erfassten Stroms eine Hinweiseinrichtung (34) zur Hinweisgabe an einen Nutzer angesteuert und/oder ein Hinweissignal an eine externe Einrichtung (5) übertragen wird.

## Claims

1. Power supply for an x-ray emitter (2) with a first and second high-voltage terminal (11, 12) for connecting the x-ray emitter (2), wherein a voltage source (35) of the power supply (3) is configured to provide an acceleration voltage or a heating voltage between a first internal contact (18) and a second internal contact (19) of the power supply (3), in order, in a first operating mode of the power supply (3), to supply the x-ray emitter (3) with power, **characterised in that** the power supply (3) comprises a control device (16), which is configured, in a second operating mode, to detect a voltage between the first and the second internal contact (18, 19) and/or a current via the first and/or second internal contact (18, 19) and, as a function of the voltage detected and/or the current detected, to activate a warning device (34) for giving a warning to a user and/or to transmit a warning signal to an external device (5), wherein a switching device (17) of the power supply (3) is configured to connect the first internal contact (18) in the first operating mode to the first high-voltage terminal (11) and in the second operating mode to disconnect it from said terminal, and/or is configured, in the first operating mode, to connect the second internal contact (19) to the second high-voltage terminal (12) and in the second operating mode to disconnect it from said terminal, and/or is configured in the second operating mode to connect the first and second internal contact (18, 19) and to disconnect them in the first operating mode.

2. Power supply according to claim 1, **characterised in that** the voltage source (35) has a further internal contact (21) and is configured to apply an acceleration voltage between the further internal contact (21) and the first and/or second internal contact (18, 19), wherein the switching device (17) is configured to connect the further internal contact (21) in the first operating mode to a further high-voltage terminal (14) and in the second operating mode to disconnect it from said terminal.

3. Power supply according to claim 2, **characterised in that** the control device (16) is configured, in the second operating mode, to detect a voltage between the further internal contact (21) and the first or second internal contact (18, 19), wherein the activation of the warning device (34) and/or the transmission of the warning signal additionally depends on this voltage.

4. Power supply according to one of the preceding claims, **characterised in that** the control device (16) is configured, in the first operating mode, to detect the current via the first and/or second internal contact (18, 19) and/or the voltage between the first and the second internal contact (18, 19) and/or the voltage between the further and the first and/or second internal contact (21, 18, 19) as the respective measurement variable and, when a condition for switching is fulfilled, which depends on the measurement variable or the measurement variables, to switch over the power supply (3) to the second operating mode.

5. Power supply according to one of the preceding claims, **characterised in that** the switching facility (17) comprises a first oil switch (30), which in the first operating mode connects the first internal contact (18) to the first high-voltage terminal (11) and in the second operating mode disconnects it from said terminal, and/or a second oil switch (31), which in the first operating mode connects the second internal contact (19) to the second high-voltage terminal (12) and in the second operating mode disconnects it from said terminal.

6. X-ray device, in particular for medical imaging, with an x-ray emitter (2) for generation of x-rays (6), **characterised in that** the x-ray device (1) comprises a power supply (3) according to one of the preceding claims.

7. Method for testing an x-ray device (1), wherein an x-ray emitter (2), which serves to generate x-rays (6), in a first operating mode of a power supply (3) is supplied with power through a first and second high-voltage terminal (11, 12) of the power supply (3), in that an acceleration voltage or a heating voltage is provided between a first internal contact (18) and a second internal contact (19) of the power supply (3), wherein the first internal contact (18) is connected to the first high-voltage terminal (11) and the second internal contact (19) to the second high-voltage terminal (12) by a switching device (17), wherein, if a condition for switching is fulfilled, the power supply (3) is switched over to a second operating mode, in which the switching device (17) disconnects the first internal contact (18) from the first high-voltage terminal (11) and/or the second internal contact (19) from the second high-voltage terminal (12) and, in the event of the heating voltage being provided, connects the first and second internal contact (18, 19) conductively to one another, whereafter a current via the first and/or the second internal contact (18, 19) is detected by a control device (16), or in the event of the acceleration voltage being provided, a voltage between the first and the second internal contact (18, 19) is detected by a control device (16) and as a function of the voltage detected or of the current detected, a warning device (34) for giving a warning to a user is activated and/or a warning signal is transmitted to an external device (5).

## Revendications

1. Alimentation électrique d'un émetteur (2) de rayons X ayant une première et une deuxième bornes (11, 12) pour la haute tension pour la connexion de l'émetteur (2) de rayons X, dans laquelle une source (35) de tension de l'alimentation (3) électrique est conçue pour disposer d'une tension d'accélération ou d'une tension de chauffage entre un premier contact (18) interne et un deuxième contact (19) interne de l'alimentation (3) électrique, afin d'alimenter en courant l'émetteur (3) de rayons X dans un premier mode de fonctionnement de l'alimentation (3) électrique, **caractérisée en ce que** l'alimentation (3) électrique comprend un dispositif (16) de commande, qui est conçu pour détecter, dans un deuxième mode de fonctionnement, une tension entre le premier et le deuxième contacts (18, 19) internes et/ou un courant passant par le premier et/ou le deuxième contacts (18, 19) internes et pour, en fonction de la tension détectée et/ou du courant détecté, commander un dispositif (34) indicateur pour donner une indication à un utilisateur et/ou pour transmettre un signal indicateur à un dispositif (5) extérieur, dans lequel un dispositif (17) de coupure de l'alimentation (3) électrique est conçu pour relier les premiers contacts (18) internes dans le premier mode de fonctionnement à la première borne (11) pour la haute tension et dans le deuxième mode de fonctionnement pour les en séparer, et/ou est conçu, pour relier le deuxième contact (19) interne dans le premier mode de fonctionnement à la deuxième borne (12) pour la haute tension et dans le deuxième mode de fonctionnement pour l'en séparer, et/ou est conçu pour relier le premier et le deuxième contacts (18, 19) interne dans le deuxième mode de fonctionnement et les séparer dans le premier mode de fonctionnement.

2. Alimentation électrique suivant la revendication 1, **caractérisée en ce que** la source (35) de tension a un autre contact (21) interne et est conçue pour appliquer une tension d'accélération entre l'autre contact (21) interne et le premier et/ou le deuxième contacts (18, 19) internes, dans lequel le dispositif (17) de coupure est conçu pour relier l'autre contact (21) interne dans le premier mode de fonctionnement à une autre borne (14) pour la haute tension et l'en séparer dans le deuxième mode de fonctionnement.

3. Alimentation électrique suivant la revendication 2, **caractérisée en ce que** le dispositif (16) de commande est conçu pour détecter, dans le deuxième mode de fonctionnement, une tension entre l'autre contact (21) interne et le premier ou le deuxième contacts (18, 19) internes, dans lequel la commande du dispositif (34) indicateur et/ou la transmission du signal indicateur dépend en outre de cette tension.

4. Alimentation électrique suivant l'une des revendications précédentes, **caractérisée en ce que** le dispositif (16) de commande est conçu pour détecter, dans le premier mode de fonctionnement, le courant passant par le premier et/ou le deuxième contacts (18, 19) internes et/ou la tension entre le premier et le deuxième contacts (18, 19) internes et/ou la tension entre l'autre et le premier et/ou le deuxième contact (21, 18, 19) internes comme grandeur respective de mesure et, lorsqu'une condition de changement est satisfaite, qui dépend de la grandeur de mesure ou des grandeurs de mesure, faire passer l'alimentation (3) électrique dans le deuxième mode de fonctionnement.

5. Alimentation électrique suivant l'une des revendications précédentes, **caractérisée en ce que** le dispositif (17) de coupure comprend un premier interrupteur (30) dans l'huile qui, dans le premier mode de fonctionnement, relie le premier contact (18) interne à la première borne (11) pour la haute tension et l'en sépare dans le deuxième mode de fonctionnement, et/ou un deuxième interrupteur (31) dans l'huile qui, dans le premier mode de fonctionnement, relie le deuxième contact (19) interne à la deuxième borne (12) pour la haute tension et l'en sépare dans le deuxième mode de fonctionnement.

6. Dispositif à rayons X, notamment pour l'imagerie médicale, comprenant un émetteur (2) de rayons X pour la production du rayonnement (6) X, **caractérisé en ce que** le dispositif (1) à rayons X comprend une alimentation (3) électrique suivant l'une des revendications précédentes.

7. Procédé pour tester un dispositif (1) à rayons X, dans lequel on alimente en courant un émetteur (2) de rayons X, qui sert à la production de rayonnement (6) X, dans un premier mode de fonctionnement d'une alimentation (3) électrique, par une première et une deuxième bornes (11, 12) pour la haute tension de l'alimentation (3) électrique, en disposant d'une tension d'accélération ou d'une tension de chauffage entre un premier contact (18) interne et un deuxième contact (19) interne de l'alimentation (3) électrique, dans lequel, par un dispositif (17) de coupure, on relie le premier contact (18) interne à la première borne (11) pour la haute tension et le deuxième contact (19) interne à la deuxième borne (12) pour la haute tension, dans lequel, lorsqu'une condition de remplacement est satisfaite, on fait passer l'alimentation (3) électrique dans un deuxième mode de fonctionnement, dans lequel le dispositif (17) de coupure sépare le premier contact (18) interne de la première borne (11) pour la haute tension et/ou le deuxième contact (19) interne de la deuxième borne (12) pour la haute tension et, dans le cas où l'on met à disposition la tension de chauffage, relie le premier et le deuxième contacts (18, 19) internes entre eux à conduction, dans lequel ensuite, par un dispositif (16) de commande, on détecte un courant passant par le premier et/ou le deuxième contacts (18, 19) internes ou, dans le cas de la mise à disposition de la tension d'accélération, on détecte une tension entre le premier et le deuxième contacts (18, 19) internes et, en fonction de la tension détectée ou du courant détecté, on commande un dispositif (34) indicateur donnant une indication à un utilisateur ou on transmet un signal d'indication à un dispositif (5) extérieur.
